(19) Europäisches Patentamt
European Patent Office
Office européen des brevets

(11) **EP 4 179 339 B1**

(12) **FASCICULE DE BREVET EUROPEEN**

(45) Date de publication et mention
de la délivrance du brevet:
**30.10.2024   Bulletin 2024/44**

(21) Numéro de dépôt: **21778171.5**

(22) Date de dépôt: **01.09.2021**

(51) Classification Internationale des Brevets (IPC):
*G01R 19/00* (2006.01)   *G01R 19/14* (2006.01)
*G01R 19/165* (2006.01)

(52) Classification Coopérative des Brevets (CPC):
**G01R 19/14; G01R 19/16519; H01L 27/0248;**
**H03K 17/0822;** G01R 19/0092; G01R 31/2621;
G01R 31/275; H03K 2217/0027

(86) Numéro de dépôt international:
**PCT/FR2021/051506**

(87) Numéro de publication internationale:
**WO 2022/049344 (10.03.2022 Gazette 2022/10)**

(54) **DÉTECTEUR DE POLARITE D'UN SIGNAL ALTERNATIF**

**DETEKTOR ZUR ERKENNUNG DER POLARITÄT EINES WECHSELSIGNALS**

**DETECTOR FOR DETECTING THE POLARITY OF AN ALTERNATING SIGNAL**

(84) Etats contractants désignés:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priorité: **07.09.2020   FR 2009047**

(43) Date de publication de la demande:
**17.05.2023   Bulletin 2023/20**

(73) Titulaire: **Commissariat à l'Energie Atomique et**
**aux Energies**
**Alternatives**
**75015 Paris (FR)**

(72) Inventeurs:
• **BERGOGNE, Dominique**
  **38054 Grenoble Cedex 09 (FR)**
• **ROTHAN, Frédéric**
  **38054 Grenoble Cedex 09 (FR)**

(74) Mandataire: **Brevalex**
**Tour Trinity**
**1 B Place de la Défense**
**92400 Courbevoie (FR)**

(56) Documents cités:
EP-A1- 2 515 126    EP-A1- 2 515 126
JP-A- H1 051 272    US-A- 4 525 678
US-A- 4 525 678     US-A- 5 541 799

US-A- 5 541 799     US-A1- 2005 286 194
US-A1- 2005 286 194  US-A1- 2015 003 843
US-A1- 2015 003 843  US-A1- 2018 238 937
US-A1- 2019 140 630  US-A1- 2019 140 630
US-A1- 2019 245 382  US-A1- 2019 245 382

• FAY P ET AL: "High sensitivity 12 Gb/s
monolithically integrated pin-HEMT
photoreceivers", INDIUM PHOSPHIDE AND
RELATED MATERIALS, 1998 INTERNATIONAL
CONFERENCE ON TSUKUBA, JAPAN 11-15 MAY
1998, NEW YORK, NY, USA, IEEE, US, 11 May 1998
(1998-05-11), pages 439 - 442, XP010295314,
ISBN: 978-0-7803-4220-0, DOI:
10.1109/ICIPRM.1998.712498
• PETROVIC PREDRAG B ED - KHATEB FABIAN
ET AL: "New CMOS Current-Mode Analogue to
Digital Power Converter", CIRCUITS, SYSTEMS
AND SIGNAL PROCESSING, CAMBRIDGE, MS,
US, vol. 36, no. 4, 27 July 2016 (2016-07-27), pages
1361 - 1378, XP036168190, ISSN: 0278-081X,
[retrieved on 20160727], DOI:
10.1007/S00034-016-0372-X
• ANONYMOUS: "Inverter (logic gate) - Wikipedia",
15 March 2020 (2020-03-15), XP055863183,
Retrieved from the Internet
<URL:https://en.wikipedia.org/w/index.php?title
=Inverter_(logic_gate)&oldid=945667015>
[retrieved on 20211118]

- **FAY P ET AL: "High sensitivity 12 Gb/s monolithically integrated pin-HEMT photoreceivers", INDIUM PHOSPHIDE AND RELATED MATERIALS, 1998 INTERNATIONAL CONFERENCE ON TSUKUBA, JAPAN 11-15 MAY 1998, NEW YORK, NY, USA, IEEE, US, 11 May 1998 (1998-05-11), pages 439 - 442, XP010295314, ISBN: 978-0-7803-4220-0, DOI: 10.1109/ICIPRM.1998.712498**

2

**Description**

**DOMAINE TECHNIQUE**

La présente invention a trait au domaine des circuits électroniques de détection de courant ou de tension et plus particulièrement celui des circuits permettant de détecter la polarité d'un courant alternatif ou d'une tension alternative. Elle vise en particulier un dispositif de détection de courant permettant d'indiquer la polarité du courant délivré par un transistor de puissance tel qu'un transistor HEMT (« High Electron Mobility Transistor »).

**ÉTAT DE LA TECHNIQUE ANTÉRIEURE**

Les transistors de puissance à hétérojonction tels que par exemple les transistors HEMT en GaN ont pour avantage notamment de présenter une faible résistance électrique à l'état passant, de supporter de grandes densités de courant ainsi que fortes tensions à l'état bloqué. Ils trouvent des applications notamment dans le domaine des convertisseurs d'énergie électrique, les convertisseurs DC/DC, les convertisseurs AC/DC à base d'interrupteurs bidirectionnels, les alimentations USB-PD (pour « Universal Serial Bus Power Delivery »).

Pour certaines applications, il est souhaitable de détecter si un courant traversant le transistor de puissance dépasse un seuil donné et en particulier de savoir si ce courant est ou non positif.

Le document « Fully Protected H-Bridge IR3220S », Architecture and Typical Application, Application Note AN-1032, Xavier de Frutos, 2001 propose par exemple un circuit de détection de courant positif délivré par un transistor de puissance et qui utilise la résistance du transistor à l'état passant.

Le circuit de détection présenté dans ce document est sensible aux variations de résistance en fonction de la température.

Pour réaliser une détection de même type, le document « Current Sensing Power MOSFETs Semiconductor » Application Note AND8093/D, 2002, Semiconductor Components Industries, LLC, 2002 prévoit quant à lui, de dériver une infime partie du courant de cellules formant un transistor de puissance vers un circuit de détection formé d'amplificateurs opérationnels. Un tel circuit de détection pose des problèmes d'encombrement. Par ailleurs, les amplificateurs opérationnels sont associés à un circuit de polarisation délivrant des tensions négatives, ce qui nécessite d'intégrer des portions circuits supplémentaires pour assurer ce type de polarisation. Les documents US 2018/238937 A1 et "New CMOS Current-Mode Analogue to Digital Power Converter", PB PETROVIC, CIRCUITS, SYSTEMS AND SIGNAL PROCESSING, 27 juillet 2016, pages 1361-1378, décrivent des exemples pertinents de dispositifs de détection de polarité d'un signal.

Il se pose le problème de trouver un nouveau dispositif de détection de courant issu d'un transistor de puissance et qui soit amélioré en particulier vis-à-vis d'au moins un des inconvénients donnés ci-dessus.

**EXPOSÉ DE L'INVENTION**

Selon un aspect, la présente demande concerne un dispositif de détection de la polarité d'un courant dit « détecté » alternativement positif et négatif ou d'une tension dite « détectée » alternativement positive et négative, selon la revendication 1.

Les transistors du circuit de détection peuvent être en particulier des transistors HEMT dotés d'une structure de canal réalisée dans au moins une couche GaN.

Typiquement, le seuil déterminé de tension est égal à 0 volt ou proche de 0 volt. Par proche de 0 volt, on entend égal en valeur absolue à moins de 20% de la tension d'alimentation Vdd et typiquement inférieur à 10% de la tension d'alimentation Vdd.

Selon un aspect particulier, la présente demande concerne un dispositif de détection de courant issu d'un transistor de puissance, ledit dispositif de détection de courant étant apte à indiquer lorsque le courant détecté atteint ou non au moins un premier niveau donné de courant, le dispositif de détection comprenant :

- une portion de circuit comprenant un noeud dit « de détection » couplé audit transistor de puissance et configurée pour produire audit noeud de détection une tension dite « de mesure » image d'une fraction dudit courant traversant ledit transistor de puissance,

- au moins un circuit de détection à transistor(s), couplé audit noeud de détection, ledit au moins un circuit de détection étant pourvu d'un ou plusieurs étages amplificateur(s), au moins un desdits étages amplificateurs comprenant un transistor dit « comparateur » ayant une tension grille source qui dépend de ladite tension de mesure,

ledit circuit de détection étant configuré pour comparer ladite tension de mesure à un seuil déterminé et produire en sortie un signal de détection à deux états indicateur de lorsque ledit courant détecté atteint ledit premier niveau donné de courant, ledit signal de détection adoptant un premier état lorsque ladite tension de mesure est au-dessous du seuil déterminé et adoptant un deuxième état lorsque ledit potentiel de mesure est au-dessus du seuil déterminé.

Avantageusement, le circuit de détection comprend en outre un transistor dit « de sortie » ayant un drain couplé à ladite sortie et une grille couplée au drain dudit transistor comparateur.

Selon un aspect particulier, la présente demande concerne un dispositif de détection de courant issu d'un transistor de puissance, ledit dispositif de détection de courant étant apte à indiquer lorsque le courant détecté atteint ou non au moins un premier niveau donné de courant, le dispositif de détection comprenant :

- une portion de circuit comprenant un noeud dit « de détection » couplé audit transistor de puissance et configurée pour produire audit noeud de détection une tension dite « de mesure » image d'une fraction dudit courant traversant ledit transistor de puissance,
- au moins un circuit de détection à transistor(s), couplé audit noeud de détection, ledit au moins un circuit de détection étant pourvu d'un ou plusieurs étages amplificateur(s), au moins un desdits étages amplificateurs comprenant un transistor dit « comparateur » ayant une tension grille source qui dépend de ladite tension de mesure,

ledit circuit de détection étant configuré pour comparer ladite tension de mesure à un seuil déterminé et produire en sortie un signal de détection à deux états indicateur de lorsque ledit courant détecté atteint ledit premier niveau donné de courant, ledit signal de détection adoptant un premier état lorsque ladite tension de mesure est au-dessous du seuil déterminé et adoptant un deuxième état lorsque ledit potentiel de mesure est au-dessus du seuil déterminé.

Selon une possibilité de mise en oeuvre du dispositif, le transistor de puissance est un transistor HEMT doté d'une structure de canal à base de GaN.

Dans ce cas, de manière avantageuse, le ou les transistors dudit au moins un circuit de détection peuvent être également des transistors HEMT dotés d'une structure de canal réalisée dans au moins une couche GaN. Une mise en oeuvre du transistor de puissance et du circuit de détection dans une même telle technologie peut permettre notamment une co-intégration dans une même puce et de gagner ainsi en compacité.

Selon une possibilité de mise en oeuvre, le transistor de puissance, la portion de circuit dotée du noeud de détection, et ledit ou lesdits circuit(s) de détection peuvent être intégrés sur un même substrat.

Typiquement, le circuit de détection comprend un transistor dit « de sortie » ayant un drain couplé à ladite sortie, ledit transistor de sortie ayant une grille couplée au drain dudit transistor comparateur. Un tel transistor de sortie peut servir à la mise en forme du signal résultant de la détection et à l'obtention d'un signal carré.

Avantageusement, le transistor de sortie et ledit transistor comparateur dudit circuit de détection sont de type normalement bloqué (« normally off »).

Selon une mise en oeuvre particulière du dispositif, le noeud de détection peut être couplé à la source d'un transistor dit « d'entrée » dudit circuit de détection. Une telle configuration peut permettre d'obtenir une chaîne d'amplification avec une faible impédance d'entrée.

Un premier mode de réalisation du dispositif de détection prévoit que le premier niveau donné de courant est un niveau de courant positif. Le circuit de détection produit dans ce cas sur ladite sortie un signal de détection indicateur de détection de courant positif. Les étages amplificateur(s) forment typiquement une chaîne d'amplification à gain positif.

Selon une mise en particulière de ce premier mode de réalisation, le noeud de détection est couplé à la source d'un transistor dit « d'entrée » dudit circuit de détection, ledit transistor d'entrée étant doté d'une électrode de drain couplée à la grille dudit transistor comparateur, ledit transistor comparateur ayant une source mise à un potentiel fixe.

Le transistor d'entrée peut être avantageusement monté en diode.

De manière avantageuse, le transistor d'entrée peut être un transistor de type normalement bloqué, ce qui peut permettre de rendre plus aisé le réglage du seuil de détection.

Un deuxième mode de réalisation prévoit que le premier niveau donné de courant est un niveau de courant négatif, ledit circuit de détection produisant alors en sortie un signal de détection indicateur d'une détection de courant négatif.

Les étages amplificateur(s) peuvent dans ce cas former une chaîne d'amplification à gain négatif.

Selon une possibilité de mise en oeuvre de ce deuxième mode, le noeud de détection est couplé à la source du transistor comparateur, ledit transistor comparateur étant monté en grille commune. La grille du transistor comparateur peut être alors couplée à un transistor monté en diode.

Selon une autre possibilité de mise en oeuvre de ce deuxième mode, le noeud de détection peut être est couplé à la grille d'un transistor dit « d'entrée » dudit circuit de détection, le transistor d'entrée ayant un drain couplé à la grille dudit transistor comparateur.

Selon un troisième mode de réalisation du dispositif de détection, le circuit de détection est doté d'un transistor dit « d'entrée » dont soit l'électrode de source soit l'électrode de grille peut être couplée au noeud de détection. Le choix de l'électrode sur laquelle la tension de mesure est injectée dépend alors de si l'on souhaite détecter un niveau de courant positif ou bien négatif.

Avantageusement, pour ce troisième mode, ledit transistor d'entrée peut être doté d'une électrode de drain couplée à la grille dudit transistor comparateur et à un transistor formant une charge active.

Selon une autre possibilité de mise en oeuvre, le premier niveau donné de courant dudit courant détecté peut être un niveau de courant positif, ledit circuit de détection produisant alors un signal de détection indicateur d'une détection de courant positif. Dans ce cas, le dispositif peut être doté en outre d'au moins un deuxième circuit de détection, ledit deuxième circuit de détection à transistor(s) étant pourvu d'au moins un étage d'amplification comprenant au moins un transistor de comparaison dont la tension grille source dépend de ladite tension de mesure, ledit deuxième circuit de détection étant configuré pour produire en sortie un autre signal de détection à deux états, ledit autre signal de détection étant un signal à deux états apte à indiquer lorsque ledit courant détecté est négatif.

Le circuit de détection comprend typiquement un circuit de polarisation des transistors. Avantageusement, ce circuit de polarisation est alimenté uniquement par une tension d'alimentation positive, ce qui permet là encore de gagner en compacité.

De même, de manière avantageuse, le circuit de détection peut être configuré de sorte que ledit premier état et ledit deuxième état correspondent à des niveaux de tension positifs dudit signal de détection. Un tel signal a pour avantage de pouvoir être aisément exploité en aval, en particulier par un circuit numérique de traitement.

## BRÈVE DESCRIPTION DES DESSINS

La présente invention sera mieux comprise sur la base de la description qui va suivre et des dessins en annexe sur lesquels :

La figure 1 sert à illustrer un dispositif de détection de courant tel que mis en oeuvre suivant un mode de réalisation de la présente invention et muni d'un circuit à transistors formant une chaîne d'amplification permettant de détecter lorsque le courant traversant le transistor de puissance est positif.

La figure 2 sert à illustrer différents signaux mis en oeuvre au sein du dispositif de détection de la figure 1.

La figure 3 sert à illustrer un autre mode de réalisation du dispositif de détection de courant muni cette fois d'un circuit de détection pour détecter lorsque le courant traversant un transistor de puissance est négatif.

La figure 4 sert à illustrer des signaux de sortie du circuit de détection de courant positif et du circuit de détection de courant négatif, pour différentes performances des transistors de la chaîne d'amplification.

La figure 5 sert à illustrer un dispositif de détection de courant muni à la fois d'un circuit de détection de courant négatif et d'un circuit de détection de courant positif.

La figure 6 sert à illustrer différents signaux mis en oeuvre au sein d'un dispositif de détection de courant avec détection de courant négatif et de courant positif.

La figure 7 sert à illustrer une variante de réalisation du circuit de détection, ne faisant pas partie de l'objet revendiqué, permettant la détection d'un courant positif.

La figure 8 sert à illustrer une variante de réalisation du circuit de détection, ne faisant pas partie de l'objet revendiqué, permettant la détection d'un courant négatif.

La figure 9 sert à illustrer une variante de réalisation de circuit de détection de courant, ne faisant pas partie de l'objet revendiqué, pouvant s'adapter soit à la détection de courant négatifs soit à la détection de courant positif.

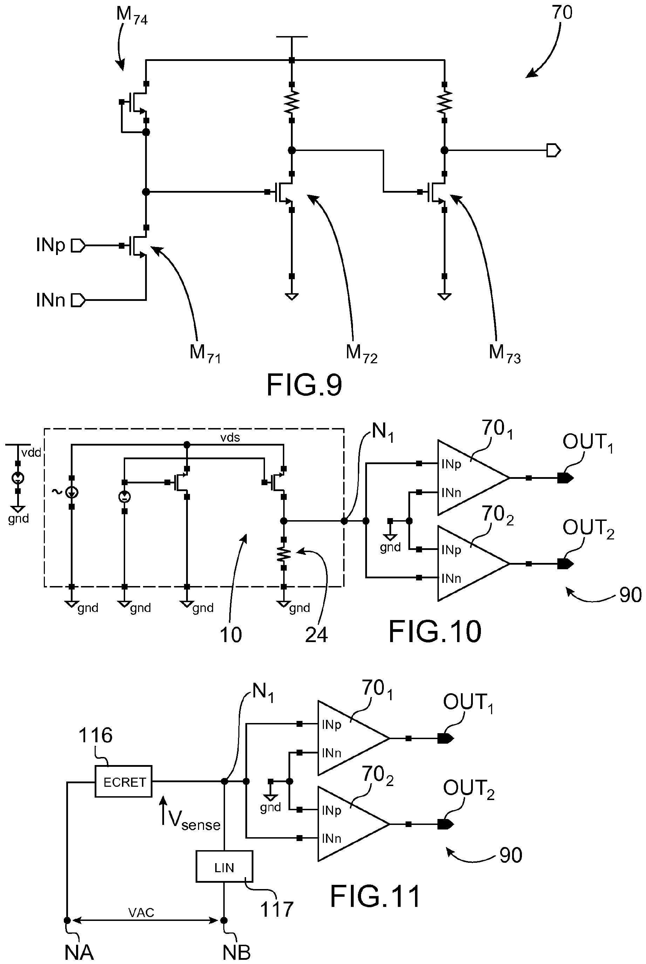

La figue 10 sert à illustrer un dispositif de détection de courant, ne faisant pas partie de l'objet revendiqué, muni de deux circuits de détection tel qu'illustré sur la figure 9, un premier étant adapté à la détection de courant négatif, un deuxième étant adapté à la détection de courant positif.

La figure 11 sert à illustrer un exemple de dispositif de détection de polarité d'une tension alternative, ne faisant pas partie de l'objet revendiqué.

Des parties identiques, similaires ou équivalentes des différentes figures portent les mêmes références numériques de façon à faciliter le passage d'une figure à l'autre. Les différentes parties représentées sur les figures ne le sont pas nécessairement selon une échelle uniforme, pour rendre les figures plus lisibles.

## EXPOSÉ DÉTAILLÉ DE MODES DE RÉALISATION PARTICULIERS

Un dispositif, tel que mis en oeuvre suivant un mode de réalisation de la présente invention, de détection d'un niveau de courant d'un transistor de puissance, va à présent être décrit.

La détection est réalisée à partir d'une tension de mesure image d'une fraction du courant traversant le transistor de puissance. On met en particulier en oeuvre une détection de la polarité du courant en détectant un passage d'un seuil de cette tension de mesure, en particulier un passage à zéro ou proche de zéro, en utilisant un circuit formant au moins un amplificateur, de préférence à grand gain, et qui est muni typiquement d'au moins un transistor monté en source commune ou en grille commune et qui reçoit la tension de mesure ou une tension qui dépend de la tension de mesure.

Le dispositif de détection est de préférence configuré pour délivrer un signal de sortie de type tout ou rien, autrement dit un signal binaire ou à deux états, en fonction de la détection ou non d'un niveau de courant donné délivré par le transistor de puissance. Le signal de sortie est ainsi exploitable par un circuit numérique. Ce signal de sortie adopte un état, autrement dit un niveau de tension lorsque le courant est inférieur à un niveau de courant donné, et adopte un autre état, autrement dit un autre niveau de tension, lorsque le courant dépasse le niveau de courant donné.

Le transistor de puissance peut être en particulier un transistor de type N et susceptible de délivrer un courant bidirectionnel, autrement dit qui peut être positif ou négatif. Le transistor de puissance est avantageusement un transistor à effet de champ à hétéro-structure, typiquement un transistor à haute mobilité électronique (HEMT) dont la structure comporte deux matériaux semi-conducteurs de bande interdite différente.

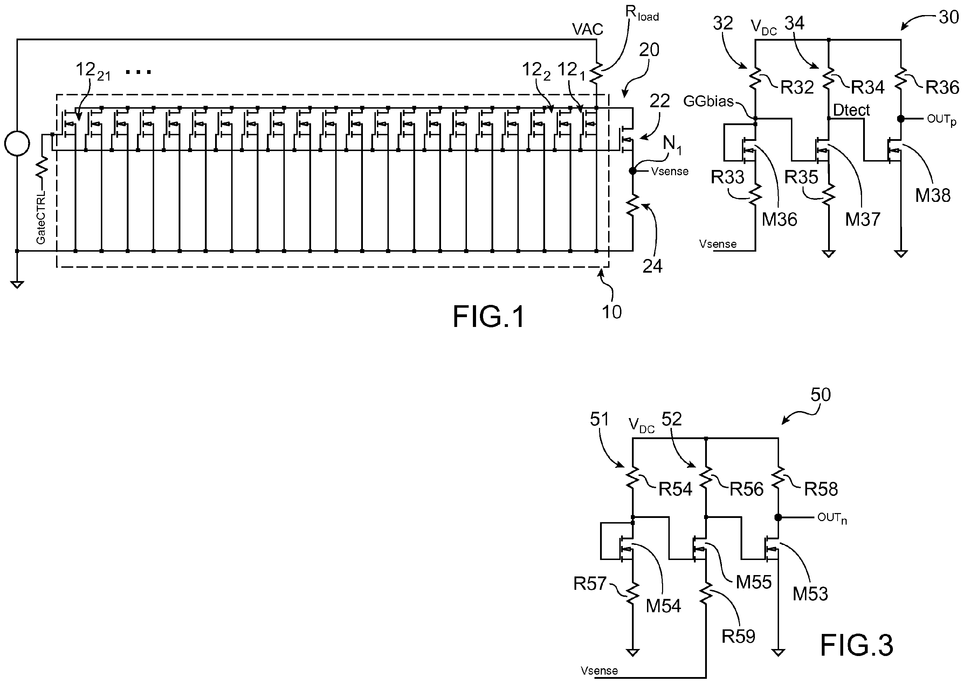

Dans l'exemple de réalisation illustré sur la figure 1, le transistor de puissance 10 considéré est un transistor HEMT en GaN c'est-à-dire doté d'une structure de canal au moins en partie réalisée dans une couche de GaN. Ce transistor 10 peut être formé d'une pluralité de cellules en parallèle représentées sous forme d'une pluralité de transistors $12_1$, ...,$12_{21}$ agencés en parallèle et partageant une électrode de drain commune et une électrode de source commune. Le document de L. Di Cioccio et al., "From epitaxy to converters topologies what issues for 200 mm GaN/Si?," 2015 IEEE International Electron Devices Meeting (IEDM), Washington, DC, 2015, pp. 16.5.1-16.5.4, doi: 10.1109/IEDM.2015.7409712, présente une réalisation technologique d'un tel type de transistor.

Une fraction du courant de drain issue du transistor 10 est convertie par le biais d'un étage 20 de conversion courant-tension. Cet étage 20 est ici doté d'un élément résistif 24 qui est placé en série avec un transistor 22, typiquement de même type que les transistors $12_1$, ...,$12_{22}$. Une partie de courant de drain du transistor de puissance 10 est ainsi dérivée et retourne sur un noeud commun aux transistors $12_1$, ...,$12_{22}$.

Un noeud dit « de détection » $N_1$, couplé à la source du transistor 22 et situé entre le transistor 22 et la résistance 24, permet de produire une tension dite « de mesure » $V_{sense}$ qui est l'image de cette fraction du courant dont on souhaite détecter la polarité ou dont souhaite vérifier s'il dépasse ou non un niveau donné.

La tension de mesure $V_{sense}$ image d'une partie du courant à détecter est appliquée en entrée d'un circuit 30 de détection à transistors $M_{36}$, $M_{37}$, $M_{38}$ formant un amplificateur à plusieurs étages ou une chaîne d'amplificateurs.

A titre d'exemple, le niveau de la tension de mesure $V_{sense}$ peut être inférieur à 100 mV pour un courant maximal traversant le transistor de puissance de l'ordre de 1A.

On choisit ici de préférence une résistance 24 de valeur rsens importante, par exemple d'au moins 10 à 100 fois celle de la résistance $R_{ON\_mes}$ à l'état passant du transistor 22, afin de dériver une faible quantité de courant émanant du transistor de puissance.

Par exemple, dans le cas où la résistance $R_{ON\_mes}$ à l'état passant du transistor 22 est de l'ordre de 10 ohms, on peut prévoir la résistance 24 comprise entre 100 ohms et 1 kΩ. Typiquement, la résistance équivalente Ron à l'état passant des transistors $12_1$, ...,$12_{22}$ connectés en parallèle est inférieure à 10 Ohms afin d'assurer un rendement élevé du convertisseur de puissance.

Le circuit 30 de détection est ici particulièrement adapté à une gamme importante de tension de mesure $V_{sense}$ laquelle gamme peut dépendre des variations du procédé de fabrication du transistor de puissance 10 utilisé.

Le circuit 30 de détection, est ici un circuit dit « de détection de tension positive », et fonctionne en boucle ouverte. Dans cet exemple de réalisation, le circuit 30 de détection de tension positive permet de détecter un courant positif en détectant un passage au-dessus de zéro de la tension de mesure $V_{sense}$. La chaîne d'amplificateurs a ainsi un gain global positif.

Le circuit 30 de détection est en particulier pourvu d'un premier transistor $M_{36}$, appelé « transistor d'entrée » recevant le signal de mesure Vsense, suivi d'un deuxième transistor $M_{37}$ monté en source commune, suivi d'un troisième transistor $M_{38}$ appelé « transistor de sortie », qui produit un signal $OUT_p$ à deux états, susceptible d'alterner entre une tension, par exemple de l'ordre de 0 Volt, et une autre tension par exemple de l'ordre d'au moins 3 Volts.

Les transistors $M_{36}$, $M_{37}$, $M_{38}$ sont de préférence du même type que le transistor 10 de puissance, en particulier des transistors HEMT, typiquement avec une structure de canal à base de GaN. Les transistors $M_{36}$, $M_{37}$, $M_{38}$ peuvent être ainsi intégrés sur un même substrat et réalisés dans un même empilement technologique que le transistor de puissance 10. Le transistor 10 de puissance et son circuit 30 de détection associé peuvent être ainsi avantageusement co-intégrés dans une même puce afin de gagner en compacité.

Les transistors $M_{37}$, $M_{38}$ sont typiquement des transistors normalement bloqués (« normally off » ou « n-off » selon la terminologie anglo-saxonne) ou à enrichissement, c'est-à-dire avec une tension de seuil positive et qui sont bloqués lorsque leur tension grille source est nulle. L'utilisation d'un tel type de transistor permet d'assurer un niveau de polarisation de grille adéquat pour pouvoir délivrer une tension de sortie de niveau suffisant. Les transistors $M_{37}$, $M_{38}$ supportent dans cet exemple une tension de grille de l'ordre de la tension de drain du transistor $M_{36}$, soit une tension de l'ordre de 1.5V.

Le circuit de polarisation des transistors $M_{36}$, $M_{37}$, $M_{38}$ est ici doté d'une tension d'alimentation VDC positive, par exemple de l'ordre de 6 volts, et de résistances $R_{32}$, $R_{33}$, $R_{34}$, $R_{35}$, $R_{36}$. Ce circuit de polarisation est prévu de préférence de manière à faire fonctionner les transistors $M_{36}$, $M_{37}$, $M_{38}$ en saturation, en particulier en réalisant un choix adéquat des résistances $R_{32}$, $R_{34}$, $R_{36}$. Les Résistances $R_{33}$ et $R_{35}$ permettent de rendre le circuit moins sensible aux variations technologiques. Ces résistances sont optionnelles et on peut s'en passer en particulier lorsqu'on cherche à privilégier le gain global du montage.

Les branches 31, 32 de circuit, contenant respectivement le transistor $M_{36}$, et le transistor $M_{37}$ sont ici prévues avec des résistances $R_{32}$, $R_{34}$ identiques $R_{32}=R_{34}=R_L$ par exemple de l'ordre de 10 kΩ à 40 kΩ de sorte à réaliser une polarisation des transistors $M_{36}$, $M_{37}$ en saturation, de manière à obtenir un gain maximal et un seuil de détection de courant faible. A titre d'exemple, on peut prévoir des résistances $R_{36}$, $R_{33}$, $R_{35}$, respectivement de 7.5 kΩ, 50 Ω et 100 Ω. les résistances $R_{32}$ et $R_{34}$ ne sont pas nécessairement identiques. En pratique, on recherche un gain maximal pour chaque étage, et on polarise ainsi dans l'exemple illustré chaque branche de la même façon, l'optimum étant le même pour tous les étages.

La tension de mesure $V_{sense}$ image d'une partie du courant à détecter est appliquée à la branche 31 et en particulier au transistor d'entrée. Les variations de la tension de mesure $V_{sense}$ viennent introduire un déséquilibre entre les branches 31, 32 et en particulier entre les potentiels GGbias et VDtect dont on se sert pour réaliser la détection.

La tension de mesure $V_{sense}$ est, dans cet exemple, appliquée à la source du transistor $M_{36}$ d'entrée par l'intermédiaire de la résistance $R_{33}$, ce qui permet d'obtenir une chaîne d'amplification à faible impédance d'entrée. On peut se passer de la résistance R33 lorsqu'on souhaite augmenter le gain du système et donc sa sensibilité, et diminuer (en valeur absolue) le seuil de détection de courant.

Dans l'exemple de réalisation particulier illustré sur la figure 1, le transistor d'entrée $M_{36}$ est également un transistor normalement bloqué (« normally off »), ce qui permet de faciliter le réglage du seuil de détection du circuit, ce seuil dépendant des différents points de polarisation imposés aux transistors.

Le transistor d'entrée $M_{36}$ est monté en diode avec une électrode de grille reliée à son drain et produit, au niveau de l'électrode de drain, un potentiel GGbias qui dépend de la tension de mesure $V_{sense}$. Ce potentiel GGbias est appliqué à la grille du transistor $M_{37}$ nommé « transistor comparateur ».

Le transistor $M_{37}$ comparateur a ici une source couplée à la masse via la résistance $R_{35}$ et ainsi reliée à un potentiel fixe ou sensiblement fixe. Sa tension grille source qui détermine son état de conduction, passant ou bloqué, dépend ainsi de l'évolution de la tension de mesure $V_{sense}$. Le transistor $M_{37}$ comparateur produit un potentiel VDtect sur son drain, lui-même couplé à la grille d'un transistor $M_{38}$, dit « de sortie », le drain du transistor $M_{38}$ produisant le signal de sortie OUTp. Le transistor $M_{38}$ de sortie permet de produire un signal OUTp carré ou binaire indicateur, en fonction de son état, d'une polarité positive du courant du transistor de puissance 10. Le signal OUTp délivré en sortie est ici une tension positive qui est comprise entre GND et VDC, le signal étant ici à GND, par exemple 0 volt, lorsque le seuil de détection n'est pas atteint et ici à VDC, typiquement supérieur à 3 volts, lorsque le seuil de détection est atteint.

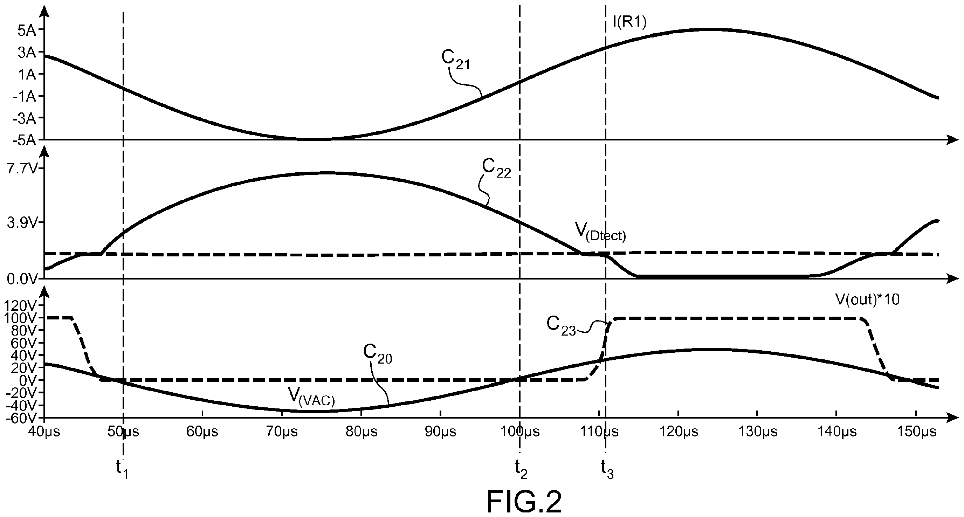

La figure 2 sert à illustrer le fonctionnement du circuit de détection 30 précédemment décrit lorsque l'on applique un signal de test VAC sinusoïdal alternant entre des valeurs négatives et des valeurs positives au transistor 10 de puissance en utilisant un pilote de grille (non représenté) qui accepte un signal de faible puissance et produit une entrée de commande GateCTRL de puissance plus importante pour commander la grille du transistor 10.

On provoque ainsi un passage de courant alternativement négatif et positif dans le transistor 10 de puissance.

Les courbes $C_{20}$, $C_{21}$, $C_{22}$, $C_{23}$ sont représentatives respectivement du signal de test VAC, du courant I($R_1$) traversant le transistor de puissance 10, du potentiel V(Dect) du noeud Dtect produit par le transistor $M_{37}$ et délivré à la grille du transistor $M_{38}$ de sortie, du signal OUTp tout ou rien de sortie du circuit de détection 30.

A un instant $t_1$, le niveau de courant est négatif et par conséquent inférieur au niveau de courant que l'on souhaite détecter.

La tension grille source du transistor $M_{37}$ comparateur est telle que ce transistor $M_{37}$ se trouve dans un état proche de l'état bloqué, de sorte que la grille du transistor $M_{38}$ de sortie est portée à une tension proche de la tension d'alimentation $V_{DC}$ supérieure et mise ainsi à une tension supérieure à la tension de seuil de ce transistor $M_{38}$. Le transistor $M_{38}$ a, par conséquent, une tension grille source le plaçant dans un état de conduction donné, ici un état passant, de sorte que le signal OUTp en sortie du circuit 30 se trouve à un premier niveau de tension, ici à la masse GND, correspondant à un premier état, indicateur que le courant détecté est en dessous du niveau de détection.

Lorsque, à un instant $t_2$, le courant passe audessus du niveau de détection, en particulier change de signe et passe ici à un niveau de courant positif, la tension mesurée Vmes change également de signe et devient positive, ce qui vient modifier la tension grille source du transistor $M_{37}$ comparateur et vient modifier son état de conduction lorsque le seuil de détection est dépassé (instant $t_3$),ce seuil de détection n'est donc ici pas placé à 0A, mais à un niveau de courant légèrement supérieur.

Le transistor $M_{37}$ bascule dans un autre état, ici passant, ce qui modifie le potentiel de drain du transistor $M_{37}$ comparateur appliqué à la grille du transistor $M_{38}$ de sortie et le fait diminuer et entraine une modification de la tension grille source du transistor $M_{38}$ de sortie de sorte à modifier l'état de conduction du transistor $M_{38}$. Le transistor $M_{38}$ de sortie bascule vers un autre état de conduction, ici bloqué. La sortie OUTp est alors couplée à la tension d'alimentation VDC, le signal OUTp de sortie étant alors à un deuxième niveau de tension correspondant par exemple à un niveau logique '1' indicateur que le courant détecté est au-dessus du niveau de détection et en particulier positif.

Une variante de circuit de détection de courant, est donnée sur la figure 3.

Le circuit 50, ici appelé circuit de détection de tension négative, est également avantageusement doté de transistors $M_{54}$, $M_{55}$, $M_{53}$, formant une chaîne d'amplificateurs. Dans cet exemple de réalisation, le circuit 50 est à gain global négatif et permet dans ce cas de détecter un courant négatif traversant le transistor de puissance 10.

Les transistors $M_{54}$, $M_{55}$, $M_{53}$ sont également de préférence du même type que le transistor 10 de puissance, en particulier des transistors HEMT à base de GaN, et peuvent, là encore, être avantageusement intégrés sur un même substrat et réalisés dans un même empilement technologique que le transistor de puissance 10.

Dans cet exemple de réalisation particulier, les transistors $M_{54}$, $M_{55}$, $M_{53}$ sont de type normalement bloqué (« normally off»).

Le circuit 50 a ici pour particularité d'être doté d'un circuit de polarisation des transistors $M_{54}$, $M_{55}$, $M_{53}$, fonctionnant uniquement avec une tension d'alimentation VDC positive, par exemple de l'ordre de 6 volts, sans donc que l'on ait besoin d'élément(s) de circuit supplémentaire(s).

Le circuit de polarisation, dans cet exemple doté de résistances R54, R56, R58, R57, R59 est configuré de manière à polariser les transistors $M_{55}$, $M_{53}$ en régime de saturation. De même que dans l'exemple de réalisation précédemment décrit, les résistances R57 et R59 sont optionnelles et l'on peut s'en passer si l'on souhaite privilégier le gain du montage.

Avantageusement, afin d'assurer un même niveau de courant la dans chacune des branches 51, 52, 53 de polarisation des transistors $M_{54}$, $M_{55}$, $M_{53}$, tout en ayant la meilleure sensibilité en courant on peut prévoir des résistances R54, R56, R58, identiques avec R54=R56=R58=RL.

Le noeud de détection $N_1$ est couplé cette fois à la source d'un transistor $M_{55}$ comparateur dont la grille est mise à un potentiel fixe ou constant VGGbias. Le transistor $M_{55}$ a une tension grille source, qui dépend là encore du signal de mesure Vsense, et en particulier de son signe. Pour polariser la grille du transistor $M_{55}$ comparateur, on prévoit ici un transistor $M_{54}$ monté en diode, ce qui permet d'abaisser la tension grille source à laquelle le transistor $M_{55}$ bascule. Un transistor $M_{53}$ de sortie, dont la grille est couplée au drain du transistor $M_{55}$, produit le signal de sortie OUTn binaire dont l'état indique si le courant détecté est ou non négatif.

On cherche de préférence à obtenir un rapport maximal, entre le gain du montage en grille commune et Ids le courant délivré par le transistor $M_{55}$ comparateur. Pour déterminer les conditions de polarisation adéquates, on peut déterminer le rapport gain courant du transistor $M_{55}$ en fonction de sa tension de grille, pour différentes géométries. On en déduit une valeur de courant I0 qui maximise ce rapport, et donc une tension grille-source Vgs au-delà de laquelle le transistor change d'état de conduction et une valeur RL de résistance.

Le circuit 50 peut fonctionner de la manière suivante : lorsque, le niveau de courant du transistor de puissance est positif, la tension grille source du transistor $M_{55}$ comparateur du circuit 50 de détection de tension négative est telle que ce transistor $M_{55}$ se trouve dans un état de conduction donné, dans le cas présent bloqué. La grille du transistor $M_{53}$ de sortie est alors couplée à l'alimentation $V_{DC}$, ce transistor $M_{53}$ de sortie ayant par conséquent une tension grille source le plaçant dans un état de conduction donné, ici un état passant. Un signal OUTn en sortie du circuit 50 se trouve à un premier niveau de tension, ici à la masse GND correspondant à un premier état, caractérisant par exemple un niveau logique '0'. Le signal OUTn indique alors qu'un courant négatif n'a pas été détecté. Le courant traversant le transistor 10 de puissance change de signe et devient négatif, ce qui entraîne un changement de signe de la tension de mesure $V_{sense}$, qui vient modifier la tension grille source du transistor $M_{55}$ comparateur et modifier son état de conduction. Le transistor $M_{55}$ passe ici dans un état passant, de sorte que la grille du transistor $M_{53}$ de sortie est couplée à l'entrée et dépend du niveau de la tension de mesure $V_{sense}$. Cela vient modifier la tension grille source du transistor $M_{53}$ de sortie et donc son état de conduction, le transistor $M_{53}$ devenant bloqué, de sorte que le signal OUTn en sortie est tiré vers la tension d'alimentation VDC, le signal OUTn étant alors dans un deuxième état, par exemple caractérisant un niveau logique '1'.

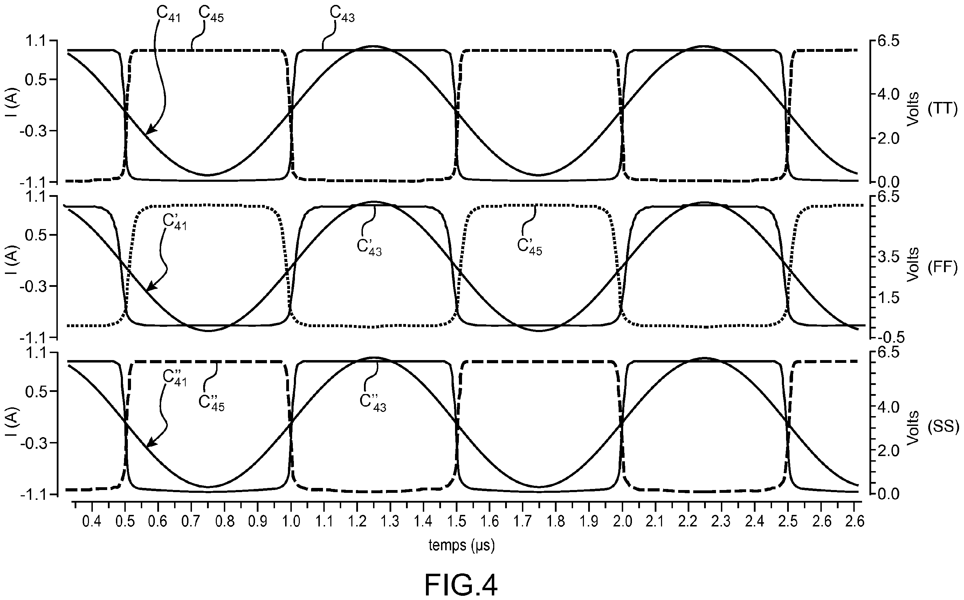

L'un ou l'autre des circuits de détection décrits précédemment sont robustes aux dispersions de fabrication, comme le montre la figure 4.

Cette figure donne en effet des résultats de simulations du fonctionnement des circuits 30, 50 décrits précédemment, pour différentes performances de transistors TT (pour "typical-typical", i.e. typique-typique), FF (pour « fast-fast », i.e. rapide-rapide), SS (pour "slow-slow", i.e. lent-lent) représentatives de variations potentielles de procédé de fabrication (« process-corners » selon la terminologie anglo-saxonne), où les courbes $C_{41}$, $C'_{41}$, $C''_{41}$, sont représentatives respectivement du courant $I(R_1)$ traversant le transistor de puissance, les courbes $C_{43}$, $C'_{43}$, $C''_{43}$, sont représentatives du signal OUTp délivré par le circuit de détection de tension positive, les courbes $C_{45}$, $C'_{45}$, $C''_{45}$, du signal OUTn délivré par le circuit de détection de tension négative. Le dimensionnement des transistors a été ici optimisé afin de réduire la consommation. La consommation globale sous une tension de 6 Volts est par exemple de 660 μA pour les transistors TT, de 900 μA pour les transistors FF, et de 500 μA pour les transistors SS.

Le circuit 50 de détection de tension négative peut être utilisé en combinaison avec le circuit 30 de détection de tension positive décrit précédemment.

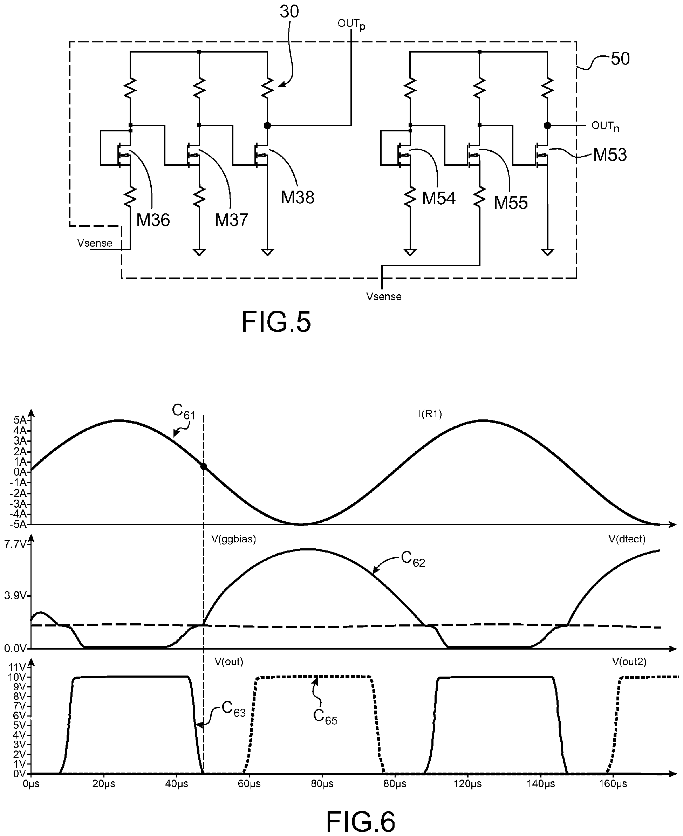

Ainsi, sur le dispositif illustré sur la figure 5, les circuits 30, 50 sont co-intégrés dans un même dispositif de détection de courant, et avantageusement réalisés sur un même substrat que le circuit 30 de détection de tension positive et le cas échéant que le transistor de puissance 10. Une co-intégration du transistor de puissance 10 et des circuits de détection 30, 50 est ainsi prévue pour réaliser un dispositif capable à la fois détecter lorsque le courant traversant le transistor de puissance 10 a une intensité négative et lorsqu'il a une intensité positive.

Un autre résultat de simulation du fonctionnement d'un dispositif comportant les deux circuits 30, 50 décrits précédemment co-intégrés est donné sur la figure 6, où les courbes $C_{61}$, $C_{62}$, $C_{63}$, Ces sont représentatives respectivement du courant $I(R_1)$ traversant le transistor de puissance, du potentiel V(Dtect) émis à la grille du transistor de sortie $M_{38}$, du signal OUTp en sortie du circuit de détection 30 de tension positive, et du signal OUTn en sortie du circuit de détection 50 de tension négative. La figure 5 illustre cette fois un mode de réalisation particulier pour lequel les deux circuits 30, 50 sont utilisés concomitamment avec une plage dite « zone morte » de détection correspondant à des valeurs de courants autour de la valeur zéro, par exemple entre 0.7A et -2.7A, qui ne sont pas détectées.

Cette zone morte peut s'avérer utile dans certains systèmes de commande, et peut permettre, par exemple, d'empêcher la mise en conduction simultanée de deux dispositifs qui seraient commandés respectivement par la sortie OUTp et la sortie OUTn des circuits détecteurs 30, 50. Une telle zone morte peut être réglée en modulant les dimensions respectives des transistors et/ou les valeurs de résistances du circuit de polarisation des transistors, en particulier les résistances $R_{33}$, $R_{35}$ du circuit de détection 30 ou $R_{57}$, $R_{59}$ de l'autre circuit de détection.

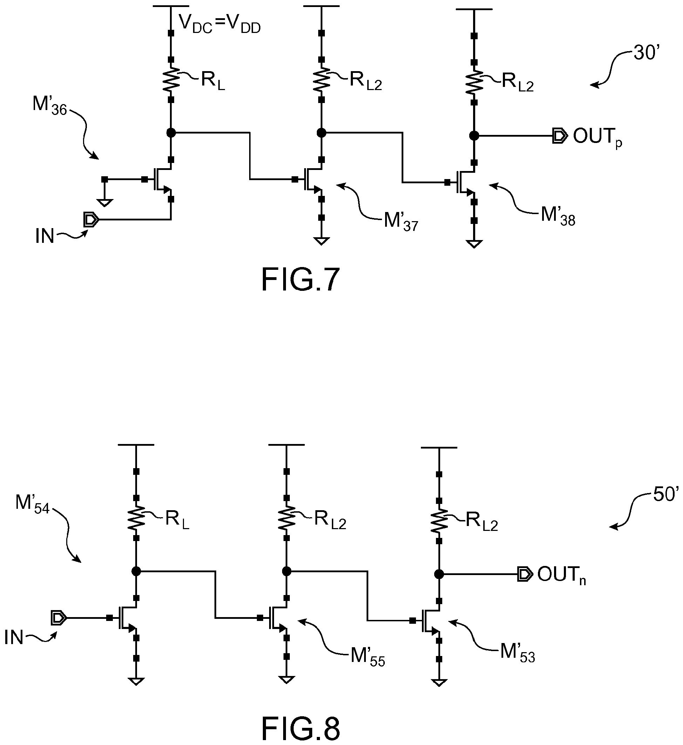

Une variante de réalisation d'un circuit de détection 30' adapté à la détection de courant positif, est donnée sur la figure 7.

Le circuit de détection 30' est doté de transistors $M'_{36}$, $M'_{37}$, $M'_{38}$ qui forment ici également une chaîne d'amplification à gain globalement positif. Le circuit 30' de détection diffère de celui décrit précédemment en liaison avec la figure 1, notamment de par son transistor d'entrée $M'_{36}$, qui, dans cet exemple, est de type normalement passant (« normally on » ou « n-on » selon la terminologie anglo-saxonne), c'est-à-dire passant lorsque sa tension grille source est nulle. Les transistors $M'_{37}$, $M'_{38}$ peuvent être quant à eux de type normalement bloqués (« normally off »).

Le transistor d'entrée $M'_{36}$ qui reçoit la tension de mesure est polarisé de sorte à être mis dans un régime en saturation, et produit un courant Ids sensiblement constant qui ne dépend que de la géométrie du transistor. Pour pouvoir maintenir ce régime, une résistance RL de la branche du circuit de polarisation auquel le drain du transistor $M'_{36}$ est relié est choisie de préférence pour remplir la condition suivante :

$$RL \leq (VDD - Vds) / Ids$$

avec $V_{DD}$, la valeur de la tension d'alimentation du circuit de polarisation, Ids le courant drain source du transistor et Vds sa tension drain-source.

Le gain en petit signal Avo de l'étage d'amplification en grille commune est de l'ordre de $gm*R_L$ avec gm, la transconductance du transistor $M'_{36}$ et $R_L$ la résistance. On peut montrer que $Av0 = (gm/I_{ds}) * (V_{dd}-V_{ds})$ à condition que la condition suivante soit respectée : $V_{ds} \geq V_{dssat}$, où $V_{dssat}$ est un paramètre technologique du transistor qui dépend de sa polarisation et de sa géométrie, et que lon peut obtenir par exemple par simulation. Les branches du circuit de polarisation auxquelles les drains respectifs des transistors $M'_{37}$, $M'_{38}$ sont reliées peuvent être prévues avec une résistance $RL_2$ différente

de la résistance $R_L$ dans la mesure où leur tension drain source VDssat en mode saturé diffère de celle du transistor de type normally on. Pour maximiser le gain, on cherche à maximiser le facteur gm/Ids et choisir Vds égal à $V_{dssat}$ pour conserver le transistor $M'_{36}$ en saturation.

Une variante de réalisation cette fois du circuit de détection adapté à la détection de courant négatif, est donnée sur la figure 8.

Le circuit de détection 50' comprend des transistors $M'_{54}$, $M'_{55}$, $M'_{53}$, qui forment ici une chaîne d'amplification à gain globalement négatif. Le circuit 50' de détection est doté d'un transistor d'entrée $M'_{54}$ cette fois monté en source commune. Ce transistor $M'_{54}$ reçoit ainsi la tension $V_{sense}$ de mesure sur sa grille. L'étage d'amplification muni de ce transistor $M'_{54}$ a ici un gain d'amplification Avo, négatif de l'ordre de $-gm*R_L$.

Le transistor d'entrée $M'_{54}$ est de type normalement passant (« normally on » ou « n-on » selon la terminologie anglo-saxonne), c'est-à-dire qui est passant lorsque sa tension grille source est nulle. Le transistor $M'_{55}$ et le transistor de sortie $M'_{53}$ sont des transistors normalement bloqués également montés en source commune et ayant un agencement semblable à celui des transistors $M_{55}$, $M_{53}$.

Un autre exemple de circuit de détection 70 est donné sur la figure 9, avec un transistor $M_{73}$ de sortie et un transistor comparateur $M_{72}$ reprenant un agencement tel que dans l'exemple décrit précédemment et avantageusement de type normalement bloqué (« normally off »). Le circuit de détection 70 comporte ici un transistor d'entrée $M_{71}$, ici de type normalement passant (« normally on ») recevant le signal de mesure $V_{sense}$, soit sur sa grille soit sur sa source correspondant respectivement à une première entrée INp, et à une deuxième entrée INn du circuit. Parmi les entrées, INn, INp celle qui n'est pas utilisée et ne reçoit donc pas le signal de mesure $V_{sense}$ peut être mise à un potentiel de référence, ici à la masse GND.

Lorsque l'on souhaite détecter un courant positif, la première entrée INp est couplée au nœud $N_1$ de détection, tandis que la deuxième entrée INn est couplée au nœud $N_1$ de détection lorsque l'on souhaite détecter un courant négatif.

Afin d'obtenir une amplification à gain élevé, le circuit de détection 70 est dans cet exemple doté en outre d'un transistor $M_{74}$ monté en source de courant et formant une charge active couplée à la grille du transistor comparateur $M_{72}$.

Afin de pouvoir à la fois détecter un courant positif et un courant négatif, on peut prévoir de dupliquer le circuit de détection 70 tel que décrit précédemment.

Dans l'exemple illustré sur la figure 10, le dispositif de détection comporte ainsi, un premier circuit de détection $70_1$ du type de celui illustré sur la figure 7 associé à un deuxième circuit de détection $70_2$ du type de celui illustré sur la figure 7. Le premier circuit de détection $70_1$ a une entrée INp qui reçoit le signal de mesure $V_{sense}$ et délivre en sortie un signal OUT1 à deux états permettant d'indiquer lorsqu'un courant positif est détecté. Le deuxième circuit de détection $70_2$ a une entrée INn qui reçoit le signal de mesure $V_{sense}$ et délivre en sortie un signal OUT2 à deux états permettant d'indiquer lorsqu'un courant négatif est détecté.

Dans l'un ou l'autre des exemples décrits précédemment le détecteur permet de détecter la polarité d'un courant alternatif.

Un détecteur à transistors selon l'un ou l'autre des modes de réalisations décrits précédemment peut être également adapté pour détecter une polarité d'une tension alternative. Ainsi, dans l'exemple de réalisation donné sur la figure 11, un circuit de détection du type de celui illustré sur la figure 10 et décrit précédemment est utilisé pour indiquer la polarité d'une tension alternative VAC, par exemple une tension alternative en entrée d'un convertisseur de puissance. Le dispositif de détection comporte ainsi, un premier circuit de détection $70_1$ du type de celui illustré sur la figure 7 associé à un deuxième circuit de détection $70_2$ du type de celui illustré sur la figure 7. Le premier circuit de détection $70_1$ a une entrée INp couplée au noeud de détection $N_1$ et délivre en sortie un signal OUT1 à deux états permettant d'indiquer lorsque la tension VAC entre deux noeuds NA, NB est positive, le deuxième circuit de détection ayant une entrée INn couplée au noeud de détection $N_1$ et délivre en sortie un signal OUT2 à deux états permettant d'indiquer lorsque courant la tension VAC est négative. Un signal de mesure Vsense au noeud $N_1$ est dans cet exemple obtenu en limitant la tension alternative VAC. Un limiteur 117 de tension est ainsi prévu entre le noeud $N_1$ et le noeud NB. Avantageusement, un écrêtage du niveau du noeud NA peut être également mis en oeuvre par le biais d'un écrêteur 116, notamment quand la tension VAC est de grande amplitude par rapport à la tension d'alimentation des circuits de détection 70. L'étage écrêteur peut ainsi permettre d'encaisser une grande partie de la tension entre les noeuds NA et NB afin d'avoir une tension Vsense qui soit comprise entre la masse et la tension d'alimentation des circuits de détection 70, permettant ainsi d'utiliser des transistors « basse tension », plus compacts et moins couteux, pour la réalisation des circuits 70.

On a ainsi une tension alternative VAC fournie entre deux noeuds NA et NB, et au moins un composant en série entre ces noeuds NA et NB et une portion du circuit de détection dotée d'un Noeud $N_1$ fournissant un signal alternatif, ici une tension Vsense image d'une fraction de la tension VAC et présentant une polarité fonction du sens de cette tension VAC.

**Revendications**

1. Dispositif de détection de la polarité d'un courant dit « détecté » alternativement positif et négatif ou d'une tension dite « détectée » alternativement positive ou négative, ledit dispositif de détection étant apte à indiquer la polarité dudit courant détecté ou de ladite tension détectée, le dispositif de détection comprenant :

- une portion de circuit (20) dotée d'un noeud ($N_1$) dit « de détection » configurée pour produire audit noeud de détection une tension ($V_{sense}$) dite « de mesure » image d'une fraction dudit courant détecté ou de ladite tension détectée,
- au moins un circuit de détection (30, 30', 50, 50', 70, $70_1$, $70_2$, 90) à transistor(s), couplé audit noeud ($N_1$) de détection, ledit au moins un circuit de détection étant pourvu d'un ou plusieurs étages amplificateur(s), au moins un desdits étages amplificateurs comprenant un transistor ($M_{37}$, $M_{55}$, $M'_{37}$, $M'_{55}$, $M_{72}$) dit « comparateur » ayant une tension grille source qui dépend de ladite tension ($V_{sense}$) de mesure,

ledit transistor comparateur ayant en outre une source mise à un potentiel fixe (GND) et une tension grille source qui dépend de ladite tension de mesure ($V_{sense}$) ou une grille mise à un potentiel fixe (VGGbias) et une tension grille source qui dépend de ladite tension de mesure ($V_{sense}$),

le circuit de détection comprenant en outre un transistor ($M_{38}$, $M_{53}$, $M'_{38}$, $M'_{53}$, $M_{73}$) dit « de sortie » ayant un drain couplé à ladite sortie, ledit transistor de sortie ayant une grille couplée au drain dudit transistor ($M_{37}$, $M_{55}$, $M'_{37}$, $M'_{55}$, $M_{72}$) comparateur,

ledit circuit de détection étant configuré pour comparer ledit potentiel ($V_{sense}$) de mesure à un seuil déterminé, et produire en sortie un signal de détection (OUTn, OUTp, $OUT_1$, $OUT_2$) binaire indicateur de la polarité du courant détecté ou de la tension détectée, ledit signal de détection adoptant un premier état lorsque ladite tension ($V_{sense}$) de mesure est au-dessous du seuil déterminé et adoptant un deuxième état lorsque ladite tension ($V_{sense}$) de mesure est au-dessus du seuil déterminé,

**caractérisé en ce que** ledit noeud ($N_1$) de détection est couplé à la source d'un transistor ($M_{36}$, $M_{54}$, $M'_{36}$, $M'_{54}$) dit « d'entrée » dudit circuit de détection (30, 50) ou à la source du transistor ($M_{55}$) comparateur,

et **en ce que** le transistor d'entrée, ledit transistor comparateur ($M_{37}$, $M_{55}$, $M'_{37}$, $M'_{55}$, $M_{72}$), et ledit transistor de sortie ($M_{38}$, $M_{53}$, $M'_{38}$, $M'_{53}$, $M_{73}$) dudit circuit de détection sont de type N et normalement bloqués.

2. Dispositif de détection selon la revendication 1, dans lequel ledit circuit de détection (30, 30') produit sur ladite sortie (OUTp) un signal de détection indicateur de polarité positive, lesdits étages amplificateur(s) formant une chaîne d'amplification à gain positif, ledit

noeud (N$_1$) de détection étant couplé à la source d'un transistor (M$_{36}$, M'$_{36}$) dit « d'entrée » dudit circuit de détection (30, 30'), ledit transistor d'entrée étant doté d'une électrode de drain couplée à la grille dudit transistor comparateur (M$_{37}$), ledit transistor comparateur (M$_{37}$) ayant une source mise à un potentiel fixe (GND).

3. Dispositif de détection selon la revendication 2, ledit transistor d'entrée (M$_{36}$) étant monté en diode.

4. Dispositif de détection selon la revendication 1, dans lequel ledit noeud (N$_1$) de détection est couplé à la source du transistor (M$_{55}$) comparateur et dans lequel ledit circuit de détection (50, 50') produisant en sortie (OUTn) un signal de détection indicateur d'une détection d'une polarité négative, lesdits étages amplificateur(s) formant une chaîne d'amplification à gain négatif.

5. Dispositif de détection selon la revendication 1, dans lequel la grille du transistor comparateur (M$_{55}$) est couplée à un transistor (M$_{54}$) monté en diode.

6. Dispositif de détection selon la revendication 5, dans lequel ledit noeud (N$_1$) de détection est couplé à la grille du transistor (M'$_{54}$) dit « d'entrée » dudit circuit de détection (50'), le transistor d'entrée ayant un drain couplé à la grille dudit transistor (M'$_{55}$) comparateur.

7. Dispositif de détection selon la revendication 1, dans lequel ledit noeud (N$_1$) de détection est couplé à une électrode de source du transistor (M$_{71}$) d'entrée dudit circuit de détection (70), ledit transistor d'entrée étant doté d'une électrode de drain couplée à la grille dudit transistor comparateur (M$_{72}$) et à un transistor (M$_{74}$) formant une charge active.

8. Dispositif de détection selon la revendication 1, dans lequel ledit circuit de détection (30, 70$_1$) produit un signal de détection indicateur (OUT$_p$) d'une polarité positive, ledit dispositif étant doté d'au moins un deuxième circuit de détection (50, 70z), ledit deuxième circuit de détection à transistor(s) étant pourvu d'au moins un étage d'amplification comprenant au moins un transistor (M$_{55}$) de comparaison dont la tension grille source dépend de ladite tension (V$_{sense}$) de mesure, ledit deuxième circuit de détection (30, 50) étant configuré pour comparer ladite tension (V$_{sense}$) de mesure à un deuxième seuil prédéterminé et produire en sortie un autre signal de détection (OUT$_n$)) à deux états, ledit autre signal de détection (OUT$_n$) étant un signal à deux états apte à indiquer une polarité négative.

9. Dispositif de détection selon la revendication 8, dans lequel le circuit de détection (30, 70$_1$) et le deuxième circuit de détection (50, 70$_2$) sont configurés avec une plage dite « zone morte » de détection correspondant à des valeurs de courants autour de la valeur zéro, qui ne sont pas détectées.

10. Dispositif de détection selon l'une des revendications 1 à 9, comprenant en outre un circuit de polarisation des transistors dudit circuit de détection, ledit circuit de polarisation étant alimenté par une tension d'alimentation (VDC) positive.

11. Dispositif de détection selon l'une des revendications 1 à 10, dans lequel le courant alternatif est issu d'un transistor de puissance (10) couplé à ladite portion de circuit (20), ledit transistor de puissance étant un transistor HEMT doté d'un canal à base de GaN, le ou les transistors (M$_{36}$, M$_{37}$, M$_{38}$, M$_{54}$, M$_{55}$, M$_{53}$) dudit au moins un circuit de détection (30, 30', 50, 50', 70) étant également des transistors HEMT dotés d'une structure de canal formée dans une couche en GaN.

12. Dispositif de détection selon l'une des revendications 1 à 11, dans lequel le courant alternatif détecté est issu d'un transistor de puissance (10) couplé à ladite portion de circuit (20), le dispositif comprenant en outre le transistor de puissance (10), le transistor de puissance, ladite portion de circuit (20), et ledit au moins un circuit de détection (30, 50, 30', 50', 70, 90) étant intégrés sur un même substrat.

13. Dispositif de détection selon l'une des revendications 1 à 12, dans lequel le circuit de détection est constitué de transistors de type N et de charges de polarisation constituées de résistance et/ou de transistors.

**Patentansprüche**

1. Vorrichtung zum Detektieren der Polarität eines sogenannten "detektierten" abwechselnd positiven und negativen Stroms oder einer sogenannten "detektierten" abwechselnd positiven oder negativen Spannung, wobei die Vorrichtung zum Detektieren imstande ist, die Polarität des detektierten Stroms oder der detektierten Spannung anzugeben, wobei die Vorrichtung zum Detektieren umfasst:

- einen Schaltungsabschnitt (20), der mit einem sogenannten "Detektions"-Knoten (N$_1$) dotiert ist, der konfiguriert ist, um am Detektionsknoten eine sogenannte "Messungs"-Spannung (V$_{sense}$) als Bild einer Fraktion des detektierten Stroms oder der detektierten Spannung zu erzeugen,
- mindestens eine Detektionsschaltung (30, 30', 50, 50', 70, 70$_1$, 70$_2$, 90) mit Transistor(en), die

an den Detektionsknoten ($N_1$) gekoppelt ist, wobei die mindestens eine Detektionsschaltung mit einer oder mehreren Verstärkerstufen versehen ist, wobei mindestens eine der Verstärkerstufen einen sogenannten "Vergleicher"-Transistor ($M_{37}$, $M_{55}$, $M'_{37}$, $M'_{55}$, $M_{72}$) umfasst, der eine Gate-Source-Spannung aufweist, die von der Messungsspannung ($V_{sense}$) abhängig ist,

wobei der Vergleicher-Transistor weiter eine Source aufweist, die auf ein festes Potential (GND) gesetzt ist, und eine Gate-Source-Spannung, die von der Messungsspannung ($V_{sense}$) abhängig ist, oder ein Gate, das auf ein festes Potential (VGGbias) gesetzt ist, und eine Gate-Source-Spannung, die von der Messungsspannung ($V_{sense}$) abhängig ist,

wobei die Detektionsschaltung weiter einen sogenannten "Ausgangs"-Transistor ($M_{38}$, $M_{53}$, $M'_{38}$, $M'_{53}$, $M_{73}$) umfasst, der einen Drain aufweist, der an den Ausgang gekoppelt ist, wobei der Ausgangstransistor ein Gate aufweist, das an den Drain des Vergleicher-Transistors ($M_{37}$, $M_{55}$, $M'_{37}$, $M'_{55}$, $M_{72}$) gekoppelt ist,

wobei die Detektionsschaltung konfiguriert ist, um das Messungspotential ($V_{sense}$) mit einer bestimmten Schwelle zu vergleichen, und am Ausgang ein binäres Detektionssignal ($OUT_n$, $OUT_p$, $OUT_1$, $OUT_2$) als Indikator der Polarität des detektierten Stroms oder der detektierten Spannung zu erzeugen, wobei das Detektionssignal einen ersten Zustand annimmt, wenn die Messungsspannung ($V_{sense}$) unter der bestimmten Schwelle liegt, und einen zweiten Zustand annimmt, wenn die Messungsspannung ($V_{sense}$) über der bestimmten Schwelle liegt, **dadurch gekennzeichnet, dass**

der Detektionsknoten ($N_1$) an die Source eines sogenannten "Eingangs"-Transistors ($M_{36}$, $M_{54}$, $M'_{36}$, $M'_{54}$) der Detektionsschaltung (30, 50) oder an die Source des Vergleicher-Transistors ($M_{55}$) gekoppelt ist,

und dadurch, dass der Eingangstransistor, der Vergleicher-Transistor ($M_{37}$, $M_{55}$, $M'_{37}$, $M'_{55}$, $M_{72}$), und der Ausgangstransistor ($M_{38}$, $M_{53}$, $M'_{38}$, $M'_{53}$, $M_{73}$) der Detektionsschaltung vom N-Typ und normalerweise blockiert sind.

2. Vorrichtung zum Detektieren nach Anspruch 1, wobei die Detektionsschaltung (30, 30') am Ausgang ($OUT_p$) ein Detektionssignal als Indikator für eine positive Polarität erzeugt, wobei die Verstärkerstufen eine Verstärkungskette mit positivem Gain bilden, der Detektionsknoten ($N_1$) an die Source eines sogenannten "Eingangs"-Transistors ($M_{36}$, $M'_{36}$) der Detektionsschaltung (30, 30') gekoppelt ist, wobei der Eingangstransistor mit einer Drain-Elektrode dotiert ist, die an das Gate des Vergleicher-Transistors

($M_{37}$) gekoppelt ist, wobei der Vergleicher-Transistor ($M_{37}$) eine Source aufweist, die auf ein festes Potential (GND) gesetzt ist.

3. Vorrichtung zum Detektieren nach Anspruch 2, wobei der Eingangstransistor ($M_{36}$) als Diode montiert ist.

4. Vorrichtung zum Detektieren nach Anspruch 1, wobei der Detektionsknoten ($N_1$) an die Source des Vergleicher-Transistors ($M_{55}$) gekoppelt ist, und wobei die Detektionsschaltung (50, 50') am Ausgang ($OUT_n$) ein Detektionssignal als Indikator einer Detektion einer negativen Polarität erzeugt, wobei die Verstärkerstufen eine Verstärkungskette mit negativem Gain bilden.

5. Vorrichtung zum Detektieren nach Anspruch 1, wobei das Gate des Vergleicher-Transistors ($M_{55}$) an einen als Diode montierten Transistor ($M_{54}$) gekoppelt ist.

6. Vorrichtung zum Detektieren nach Anspruch 5, wobei der Detektionsknoten ($N_1$) an das Gate des sogenannten "Eingangs"-Transistors ($M'_{54}$) der Detektionsschaltung (50') gekoppelt ist, wobei der Eingangstransistor einen Drain aufweist, der an das Gate des Vergleicher-Transistors ($M'_{55}$) gekoppelt ist.

7. Vorrichtung zum Detektieren nach Anspruch 1, wobei der Detektionsknoten ($N_1$) an eine Source-Elektrode des Eingangstransistors ($M_{71}$) der Detektionsschaltung (70) gekoppelt ist, wobei der Eingangstransistor mit einer Drain-Elektrode dotiert ist, die an das Gate des Vergleicher-Transistors ($M_{72}$) und an einen Transistor ($M_{74}$) gekoppelt ist, der eine Wirklast bildet.

8. Vorrichtung zum Detektieren nach Anspruch 1, wobei die Detektionsschaltung (30, $70_1$) ein Indikator-Detektionssignal ($OUT_p$) einer positiven Polarität erzeugt, wobei die Vorrichtung mit mindestens einer zweiten Detektionsschaltung (50, $70_2$) dotiert ist, wobei die zweite Detektionsschaltung mit Transistor(en) mit mindestens einer Verstärkungsstufe versehen ist, die mindestens einen Vergleichstransistor ($M_{55}$) umfasst, dessen Gate-Source-Spannung von der Messungsspannung ($V_{sense}$) abhängig ist, wobei die zweite Detektionsschaltung (30, 50) konfiguriert ist, um die Messungsspannung ($V_{sense}$) mit einer zweiten vorbestimmten Schwelle zu vergleichen, und am Ausgang ein anderes Detektionssignal ($OUT_n$)) mit zwei Zuständen zu erzeugen, wobei das andere Detektionssignal ($OUT_n$) ein Signal mit zwei Zuständen ist, das imstande ist, eine negative Polarität anzugeben.

**9.** Vorrichtung zum Detektieren nach Anspruch 8, wobei die Detektionsschaltung (30, 70$_1$) und die zweite Detektionsschaltung (50, 70$_2$) mit einem sogenannten "Totzonen"-Detektionsbereich konfiguriert sind, welcher Werten von Strömen um den Wert null herum entspricht, die nicht detektiert werden.

**10.** Vorrichtung zum Detektieren nach einem der Ansprüche 1 bis 9, die weiter eine Polarisationsschaltung der Transistoren der Detektionsschaltung umfasst, wobei die Polarisationsschaltung durch eine positive Versorgungsspannung (VDC) versorgt wird.

**11.** Vorrichtung zum Detektieren nach einem der Ansprüche 1 bis 10, wobei der Wechselstrom aus einem Leistungstransistor (10) stammt, der an den Schaltungsabschnitt (20) gekoppelt ist, wobei der Leistungstransistor ein HEMT-Transistor ist, der mit einem Kanal auf Basis von GaN dotiert ist, wobei der oder die Transistoren (M$_{36}$, M$_{37}$, M$_{38}$, M$_{54}$, M$_{55}$, M$_{53}$) der mindestens einen Detektionsschaltung (30, 30', 50, 50', 70) auch HEMT-Transistoren sind, die mit einer Kanalstruktur dotiert sind, die in einer Schicht aus GaN gebildet ist.

**12.** Vorrichtung zum Detektieren nach einem der Ansprüche 1 bis 11, wobei der detektierte Wechselstrom aus einem Leistungstransistor (10) stammt, der an den Schaltungsabschnitt (20) gekoppelt ist, wobei die Vorrichtung weiter den Leistungstransistor (10) umfasst, wobei der Leistungstransistor, der Schaltungsabschnitt (20) und die mindestens eine Detektionsschaltung (30, 50, 30', 50', 70, 90) auf einem gleichen Substrat integriert sind.

**13.** Vorrichtung zum Detektieren nach einem der Ansprüche 1 bis 12, wobei die Detektionsschaltung aus Transistoren vom Typ N und aus Polarisationslasten besteht, die aus Widerstand und/oder Transistoren bestehen.

**Claims**

**1.** A device for detecting the polarity of an alternately positive and negative so-called "detected" current or of an alternately positive or negative so-called "detected" voltage, said detection device being able to indicate the polarity of said detected current or of said detected voltage, the detection device comprising:

    - a circuit portion (20) provided with a so-called "detection" node (N$_1$) configured to produce at said detection node a so-called "measurement" voltage (V$_{sense}$) image of a fraction of said detected current or of said detected voltage,
    - at least one detection circuit (30, 30', 50, 50',

70, 70$_1$, 70$_2$, 90) with transistor(s), coupled to said detection node (N$_1$), said at least one detection circuit being provided of one or more amplifier stage(s), at least one of said amplifier stages comprising a so-called "comparator" transistor (M$_{37}$, M$_{55}$, M'$_{37}$, M'$_{55}$, M$_{72}$) having a gate-source voltage which depends on said measurement voltage (V$_{sense}$), said comparator transistor further having a source set at a fixed potential (GND) and a gate-source voltage which depends on said measurement voltage (V$_{sense}$) or a gate set at a fixed potential (VGGbias) and a gate-source voltage which depends on said measurement voltage (V$_{sense}$), the detection circuit further comprising a so-called "output" transistor (M$_{38}$, M$_{33}$, M'$_{38}$, M'$_{33}$, M$_{73}$) having a drain coupled to said output, said output transistor having a gate coupled to the drain of said comparator transistor (M$_{37}$, M$_{55}$, M'$_{37}$, M'$_{55}$, M$_{72}$), said detection circuit being configured to compare said measurement potential (V$_{sense}$) with a determined threshold, and produce at the output a binary detection signal (OUTn, OUTp, OUT$_1$, OUT$_2$) indicative of the polarity of the detected current or of the detected voltage, said detection adopting a first state when said measurement voltage (V$_{sense}$) is below the determined threshold and adopting a second state when said measurement voltage (V$_{sense}$) is above the determined threshold, **characterized in that** said detection node (N$_1$) is coupled to the source of a so-called "input" transistor (M$_{36}$, M$_{54}$, M'$_{36}$, M'$_{54}$) of said detection circuit (30, 50) or to the source of the comparator transistor (M$_{55}$), and **in that** the input transistor, said comparator transistor (M$_{37}$, M$_{55}$, M'$_{37}$, M'$_{55}$, M$_{72}$), and said output transistor (M$_{38}$, M$_{53}$, M'$_{38}$, M'$_{53}$, M$_{73}$) of said detection circuit are of the N type and normally blocked.

**2.** The detection device according to claim 1, wherein said detection circuit (30, 30') produces on said output (OUTp) a detection signal indicative of a positive polarity, said amplifier stages forming a positive-gain amplification chain, said detection node (N$_1$) being coupled to the source of a so-called "input" transistor (M$_{36}$, M'$_{36}$) of said detection circuit (30, 30'), said input transistor being provided with a drain electrode coupled to the gate of said comparator transistor (M$_{37}$), said comparator transistor (M$_{37}$) having a source set at a fixed potential (GND).

**3.** The detection device according to claim 2, said input transistor (M$_{36}$) being mounted as a diode.

4. The detection device according to claim 1, wherein said detection node ($N_1$) is coupled to the source of the comparator transistor ($M_{55}$) and wherein said detection circuit (50, 50') producing at the output (OUTn) a detection signal indicative of a detection of a negative polarity, said amplifier stages(s) forming a negative-gain amplification chain.

5. The detection device according to claim 1, wherein the gate of the comparator transistor ($M_{55}$) is coupled to a transistor ($M_{54}$) mounted as a diode.

6. The detection device according to claim 5, wherein said detection node ($N_1$) is coupled to the gate of the so-called "input" transistor ($M'_{54}$) of said detection circuit (50'), the input transistor having a drain coupled to the gate of said comparator transistor ($M'_{55}$).

7. The detection device according to claim 1, wherein said detection node ($N_1$) is coupled to a source electrode of the input transistor ($M_{71}$) of said detection circuit (70), said input transistor being provided with a drain electrode coupled to the gate of said comparator transistor ($M_{72}$) and to a transistor ($M_{74}$) forming an active load.

8. The detection device according to claim 1, wherein said detection circuit (30, $70_1$) produces a detection signal ($OUT_p$) indicative of a positive polarity, said device being provided with at least one second detection circuit (50, $70_2$), said second detection circuit with transistor(s) being provided with at least one amplification stage comprising at least one comparator transistor ($M_{55}$) whose gate-source voltage depends on said measurement voltage ($V_{sense}$), said second detection circuit (30, 50) being configured to compare said measurement voltage ($V_{sense}$) with a predetermined second threshold and produce at the output another two-state detection signal ($OUT_n$), said other signal detection ($OUT_n$) being a two-state signal able to indicate a negative polarity.

9. The detection device according to claim 8, wherein the detection circuit (30, $70_1$) and the second detection circuit (50, $70_2$) are configured with a so-called "dead zone" detection range corresponding to current values around the zero value, which are not detected.

10. The detection device according to one of claims 1 to 9, further comprising a circuit for biasing the transistors of said detection circuit, said biasing circuit being supplied by a positive power supply voltage (VDC).

11. The detection device according to one of claims 1 to 10, wherein the alternating current is derived from a power transistor (10) coupled to said circuit portion (20), said power transistor being a HEMT transistor provided with a GaN-based channel, the transistor(s) ($M_{36}$, $M_{37}$, $M_{38}$, $M_{54}$, $M_{55}$, $M_{53}$) of said at least one detection circuit (30, 30', 50, 50', 70) also being HEMT transistors provided with a channel structure formed in a GaN layer.

12. The detection device according to one of claims 1 to 11, wherein the detected alternating current is derived from a power transistor (10) coupled to said circuit portion (20), the device further comprising the power transistor (10), the power transistor, said circuit portion (20), and said at least one detection circuit (30, 50, 30', 50', 70, 90) being integrated on the same substrate.

13. The detection device according to one of claims 1 to 12, wherein the detection circuit consists of N-type transistors and biasing loads consisting of resistors and/or transistors.

FIG.1

FIG.3

FIG.2

EP 4 179 339 B1

FIG.4

30

OUT$_p$

50

M36    M37    M38

M54    M55    M53

OUT$_n$

Vsense

Vsense

# FIG.5

C$_{61}$    I(R1)

5A
4A
3A
2A
1A
0A
-1A
-2A
-3A
-4A
-5A

V(ggbias)    V(dtect)

7.7V

C$_{62}$

3.9V

0.0V

V(out)    V(out2)

11V
10V
9V
8V
7V
6V
5V
4V
3V
2V
1V
0V

C$_{63}$    C$_{65}$

0µs    20µs    40µs    60µs    80µs    80µs    120µs    140µs    160µs

# FIG.6

$V_{DC}=V_{DD}$

$M'_{36}$

$R_L$

$R_{L2}$

$R_{L2}$

30'

OUT$_p$

IN

$M'_{37}$

$M'_{38}$

## FIG.7

$M'_{54}$

$R_L$

$R_{L2}$

$R_{L2}$

50'

OUT$_n$

IN

$M'_{55}$

$M'_{53}$

## FIG.8

$M_{74}$

70

INp

INn

$M_{71}$     $M_{72}$     $M_{73}$

## FIG.9

vdd

vds

gnd

gnd  gnd  gnd  gnd

10          24

$N_1$

$70_1$

INp
INn

$OUT_1$

gnd

$70_2$

INp
INn

$OUT_2$

90

## FIG.10

116

ECRET

$V_{sense}$

$N_1$

$70_1$

INp
INn

$OUT_1$

gnd

$70_2$

INp
INn

$OUT_2$

90

LIN

117

VAC

NA          NB

## FIG.11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2018238937 A1

**Littérature non-brevet citée dans la description**

- **XAVIER DE FRUTOS.** Fully Protected H-Bridge IR3220S. *Architecture and Typical Application,* 2001
- Current Sensing Power MOSFETs Semiconductor. Semiconductor Components Industries, LLC, 2002
- **PB PETROVIC.** New CMOS Current-Mode Analogue to Digital Power Converter. *CIRCUITS, SYSTEMS AND SIGNAL PROCESSING,* 27 Juillet 2016, 1361-1378
- **L. DI CIOCCIO et al.** From epitaxy to converters topologies what issues for 200 mm GaN/Si?. *2015 IEEE International Electron Devices Meeting (IEDM), Washington, DC,* 2015, 16.5.1-16.5.4